# EUROPÄISCHE PATENTSCHRIFT

(11) **EP 3 045 803 B1**
(45) Veröffentlichungstag und Bekanntmachung des Hinweises auf die Patenterteilung: **04.04.2018**
(21) Anmeldenummer: 16151164.7
(22) Anmeldetag: 14.01.2016
(51) Int. Cl.: F21V 7/00, F21V 5/00, F21S 8/00, F21Y 115/10, F21Y 105/00

(54) **LEUCHTE**
LUMINAIRE
ÉCLAIRAGE

(30) Priorität: 14.01.2015 CH 452015
(43) Veröffentlichungstag der Anmeldung: 20.07.2016
(73) Patentinhaber: Regent Beleuchtungskörper AG, 4053 Basel (CH)
(72) Erfinder: Reutter, Kornelius, 4056 Basel (CH)
(74) Vertreter: Latscha Schöllhorn Partner AG

(56) Entgegenhaltungen:
- EP-A1- 1 988 752
- EP-A2- 1 276 157
- DE-A1-102006 001 490
- US-A1- 2006 044 806
- US-A1- 2011 235 318
- US-A1- 2013 114 254

## Beschreibung

### Technisches Gebiet

Die Erfindung betrifft eine Leuchte mit einer Primärabstrahlungsrichtung zur Beleuchtung eines Vorderraums der Leuchte und einer der Primärabstrahlung entgegengesetzte Sekundärabstrahlungsrichtung zur Beleuchtung eines Rückraums der Leuchte gemäss dem Oberbegriff des unabhängigen Anspruchs 1.

Solche Leuchten umfassen typischerweise eine Platine mit einer Montageoberfläche, auf der ein LED-Leuchtmittel montiert ist und eine Optik. Die Optik deckt das LED-Leuchtmittel in dessen Abstrahlrichtung ab. Sie weist eine der Platine zugewandte Innenseite und einer der Platine abgewandten Aussenseite auf. Solche Leuchten können zur Beleuchtung von Räumen als Stehleuchten, Wandleuchten, Deckenleuchten oder Pendelleuchten eingesetzt werden.

### Stand der Technik

Zur Beleuchtung von Räumen werden heutzutage verschiedenartige Leuchten eingesetzt, die beispielsweise stehend, direkt auf Wänden, an Decken, abgependelt oder angebaut beziehungsweise befestigt sein können. Insbesondere bei Stehleuchten und bei Pendelleuchten ist es dabei häufig gewünscht, dass Licht von der Leuchte sowohl in einen Vorderraum der Leuchte als auch in einen Rückraum der Leuchte abgestrahlt wird.

Beispielsweise sind Pendelleuchten häufig dazu ausgestaltet, Licht sowohl in eine Primärabstrahlungsrichtung abzugeben, in welcher der Vorderraum der Leuchte beleuchtet werden soll, als auch in eine Sekundärabstrahlungsrichtung, in der der Rückraum der Leuchte beleuchtet werden soll. Die Primärabstrahlungsrichtung und die Sekundärabstrahlungsrichtung sind typischerweise entgegengesetzt, wobei bei Pendelleuchten erstere beispielsweise nach unten zum Boden hin und zweitere nach oben zur Decke hin verlaufen kann.

Weiter werden bei modernen Leuchten zunehmend LED-Leuchtmittel mit einer oder mehreren auf einer Platine montierten Leuchtdioden eingesetzt. LED-Leuchtmittel können aus verschiedenen Gründen vorteilhaft sein. Beispielsweise sind sie verhältnismässig langlebig, sparsam und flexibel gestaltbar. Zudem können LED-Leuchtmittel verhältnismässig präzise konfiguriert werden. Zum Beispiel können sie verhältnismässig genau definierte Lichtverteilungskurven (LVK) aufweisen, die je nach Anwendung angepasst werden können. Dabei umfassen solche Leuchten zum Festlegen der LVK beziehungsweise zum Erzeugen einer bevorzugten Ausleuchtung oder einer bestimmten Atmosphäre häufig Optiken, die jeweils einer Leuchtdiode oder auch mehreren Leuchtdioden zusammen zugeordnet sind. Zudem können die Leuchten zum gleichen Zweck auch elektronische Steuerungen, Reflektoren, Refraktoren oder ähnliche Mittel umfassen.

Da Leuchtdioden von LED-Leuchtmitteln typischerweise Licht nur in einen Halbraum beziehungsweise in einer Richtung abstrahlen, werden heutzutage zusätzliche Massnahmen getroffen, um eine Leuchte der vorstehenden Art mit entgegengesetzter Primär- und Sekundärabstrahlungsrichtung realisieren zu können. Beispielsweise ist es bekannt, in einer Leuchte zwei Platinen mit Leuchtdioden um 180° zueinander zu verdrehen, sodass sich die zugehörigen Leuchtdioden in entgegengesetzter Richtungen erstrecken. Oder es werden Leuchtdioden an beiden Seiten beziehungsweise auf beiden Oberflächen einer zugehörigen Platine montiert. Dabei werden zur sauberen Definition der LVK typischerweise auf beiden Seiten der einen oder zwei Platinen Optiken angeordnet, wobei eine die Abstrahlcharakteristika der Leuchte in den Vorderraum und eine diejenigen in den Rückraum beeinflusst.

Die vorstehend beschriebene Art von Leuchten mit jeweils entgegengesetzten Leuchtdioden, die jeweils von zugehörigen Optiken abgedeckt sein müssen, kann verschiedene Nachteile nach sich ziehen. Beispielsweise können die Leuchten konstruktiv verhältnismässig breit oder hoch sein, was aus ästhetischen und anderen Gründen meist unerwünscht ist. Zudem werden in solchen Leuchten meist verhältnismässig viele Leuchtdioden und Optiken verbaut, was den Material- und Montageaufwand der Leuchte erhöhen kann. Weiter ist in der US 2011/0235318 A1 ein röhrenförmiges LED-Leuchtmittel als Ersatz für eine Leuchtstoffröhre beschrieben.

Vor diesem Hintergrund ist es Aufgabe der nachfolgenden Erfindung, eine Leuchte vorzuschlagen, die eine effiziente und vordefinierte Ausleuchtung eines Vorder- und Rückraums in einer kompakten Bauweise ermöglicht.

### Darstellung der Erfindung

Die Aufgabe wird erfindungsgemäss durch eine Leuchte gelöst, wie sie durch die Merkmale des unabhängigen Anspruchs 1 definiert ist. Vorteilhafte Ausführungsvarianten der Erfindung ergeben sich aus den abhängigen Ansprüchen.

Insbesondere umfasst eine Leuchte mit einer Primärabstrahlungsrichtung zur Beleuchtung eines Vorderraums der Leuchte und einer der Primärabstrahlungsrichtung im Wesentlichen entgegengesetzte Sekundärabstrahlungsrichtung zur Beleuchtung eines Rückraums der Leuchte eine Platine, ein LED-Leuchtmittel und eine Optik. Die Platine weist eine Montageoberfläche auf, auf der das LED-Leuchtmittel montiert ist. Die Optik deckt das LED-Leuchtmittel beispielsweise in dessen Abstrahlbereich beziehungsweise in dessen Abstrahlrichtung ab. Sie umfasst eine der Platine zugewandte Innenseite und eine der Platine abgewandte Aussenseite. Weiter weist die Optik eine Direktlichtstruktur und eine Indirektlichtstruktur auf. Die Direktlichtstruktur leitet einen Direktlichtanteil von vom LED-Leuchtmittel abgestrahltem Licht an die Aussenseite der Optik. Die Indirektlichtstruktur leitet einen Indirektlichtanteil des vom LED-Leuchtmittel abgestrahlten Lichts an die Innenseite der Optik. Die Platine weist in einem Bereich, an dem der Indirektlichtanteil des vom LED-Leuchtmittel abgestrahlten Lichts auf eine Ebene der Montageoberfläche der Platine auftritt, eine durchgehende Öffnung auf.

Das LED-Leuchtmittel kann eine oder mehrere Leuchtdioden umfassen. Dabei ist insbesondere die Leuchtdiode des LED-Leuchtmittels an der Montageoberfläche der Platine befestigt. Andere Komponenten des LED-Leuchtmittels wie beispielsweise ein Betriebsgerät können auch an der Platine montiert sein.

Die Optik kann eine Linse sein. Sie kann insbesondere aus einem transparenten Kunststoff hergestellt sein. Dies ermöglicht, dass die Linse präzise und effizient beispielsweise in einem Spritzgussprozess hergestellt werden kann.

Das die Öffnung der Platine durchdringende von der Optik reflektierte Licht kann in Primärrichtung abgestrahlt und so zur Beleuchtung des Vorderraums der Leuchte eingesetzt werden oder in Sekundärrichtung abgestrahlt und so zur Beleuchtung des Rückraums der Leuchte.

Der Begriff "Platine" im Zusammenhang mit der erfindungsgemässen Leuchte kann sich insbesondere auf eine Leiterplatte beziehungsweise eine gedruckte Schaltung (PCB) beziehen, die ein Träger für elektronische Bauteile und insbesondere für die Komponenten des LED-Leuchtmittels wie beispielsweise Leuchtdiode oder Betriebsgerät ist. Sie dient insbesondere der mechanischen Befestigung und elektrischen Verbindung der elektronischen Bauteile. Leiterplatten bestehen üblicherweise aus elektrisch isolierendem Material mit daran haftenden, leitenden Verbindungen beziehungsweise Leiterbahnen. Als isolierendes Material ist faserverstärkter Kunststoff üblich. Es kann aber insbesondere auch Aluminium sein, was aus ästhetischen Gründen oder zur verbesserten Lichtreflexion bevorzugt sein kann.

Der Begriff "Ebene der Montageoberfläche" im Zusammenhang mit der Erfindung bezieht sich auf die Ebene, in der die Montageoberfläche liegt. Dabei tritt der Indirektlichtanteil auf diese Ebene auf, indem er die Ebene kreuzt oder von der Platine reflektiert beziehungsweise absorbiert wird.

Der Begriff "Abdecken" im Zusammenhang mit der Optik und dem LED-Leuchtmittel kann sich insbesondere darauf beziehen, dass das vom LED-Leuchtmittel abgestrahlte Licht die Optik durchdringt. Dazu kann es genügen, wenn die Optik die leuchtenden Komponenten des LED-Leuchtmittels also vor allem die eine oder mehrere Leuchtdiode(n) so umgibt, dass das abgestrahlte Licht die Optik durchdringt beziehungsweise in die Optik geleitet wird.

Indem die Optik mit ihrer Direktlichtstruktur und ihrer Indirektlichtstruktur das vom LED-Leuchtmittel abgestrahlte Licht in einen Direktlichtanteil und einen Indirektlichtanteil auftrennt und diese beiden Anteile getrennt auf ihre Aussen- und Innenseiten leitet, kann erfindungsgemäss das Licht eines LED-Leuchtmittels sowohl zur Beleuchtung des Vorderraums als auch des Rückraums verwendet werden. Die Aufteilung des Direkt- zu Indirektlichtanteils kann beispielsweise etwa 70% zu etwa 30% betragen. Die Öffnung in der Platine ermöglicht dabei, dass der Indirektlichtanteil zumindest teilweise auf die gegenüberliegende Seite der Platine gelangen kann. Damit kann erreicht werden, dass Licht auch auf einer Seite der Platine abgestrahlt werden kann, die nicht mit einer Leuchtdiode bestückt ist.

Auf diese Weise kann in der Leuchte eine oder mehrere Platinen eingesetzt werden, die nur auf einer Seite mit Leuchtdioden bestückt sind und auch nur auf dieser bestückten Seite von einer oder mehreren Optiken abgedeckt sind. Dadurch kann die Leuchte verhältnismässig kompakt und platzsparend ausgestaltet sein. Zudem kann sie verhältnismässig energieeffizient betrieben werden und verhältnismässig wenig Bauteile umfassen.

Indem in der Leuchte eine lediglich einseitig bestückte Platine verwendet werden kann, kann die Leuchte auch komponentenreduziert sein, was eine Konstruktion und Herstellung mit verhältnismässig wenig Aufwand ermöglicht. Weiter kann die Leuchte auch so ausgestaltet sein, dass die Rückseite der Platine gleichzeitig die Rückseite eines Gehäuses der Leuchte bildet. Dadurch kann die komponenten- und aufwandreduzierte Konstruktion und Herstellung der Leuchte weiter unterstützt werden.

Vorzugsweise umfasst die Indirektlichtstruktur der Optik einen Reflexionsbereich der Aussenseite der Optik, der so geformt ist, dass bezüglich des vom LED-Leuchtmittel abgestrahlten Lichts Totalreflexion auftritt. Dazu kann der Reflexionsbereich der Aussenseite poliert ausgeführt sein. Ein solcher Reflexionsbereich an der Aussenseite der Optik ermöglicht ein effizientes Umleiten des vom LED-Leuchtmittel abgestrahlten Lichts in eine quasi entgegengesetzte Richtung.

Unter dem Begriff "Totalreflexion" wird in diesem Zusammenhang ein bekanntes Phänomen verstanden, das bei sichtbarem Licht an der Grenzfläche zweier nicht absorbierender Medien mit verschieden grosser Ausbreitungsgeschwindigkeit auftritt. Dabei tritt das Licht nicht mehr überwiegend vom ersten in das zweite Medium ein, sondern wird nahezu vollständig reflektiert beziehungsweise ins erste Medium zurückgeworfen, wenn der Einfallswinkel einen bestimmten Wert, den sogenannten Grenzwinkel der Totalreflexion, überschreitet. Es ist zu beachten, dass eine totale beziehungsweise vollständige Reflexion einer Welle wie einer Lichtwelle grundsätzlich eine Idealisierung darstellt, da auch der vollständig reflektierten Strahlung in der Praxis immer ein Teil durch Absorption verloren geht.

Vorzugsweise umfasst die Direktlichtstruktur der Optik einen Zentralbereich der Aussenseite der Optik, der zentral benachbart zum LED-Leuchtmittel angeordnet ist. Ein solcher Zentralbereich ermöglicht, dass die Leuchte einen Direktlichtbereich aufweist, über den das Licht des LED-Leuchtmittels effizient abgestrahlt werden kann. Wie weiter unten detaillierter beschrieben, kann das über den Zentralbereich abgestrahlte Direktlicht über eine Einkoppelfläche und eine Auskoppelfläche der Optik gesteuert werden.

Dabei ist der Zentralbereich der Optik vorzugsweise getrübt. Die Trübung des Zentralbereichs kann beispielsweise über eine Erodierung oder Glasperlenbestrahlung der Oberfläche der Aussenseite des Zentralbereichs erzeugt werden. Alternativ dazu kann die Oberfläche der Aussenseite mit Mikrobeziehungsweise Nanostrukturen versehen sein, die das Licht streuen. Die vorstehend beschaffenen Zentralbereiche, also erodierte, glasperlenbestrahlte und/oder mit Mikrobeziehungsweise Nanostrukturen versehene, werden hier allesamt als getrübt bezeichnet. Eine solche Ausgestaltung des Zentralbereichs ermöglicht eine Definition einer erwünschten Lichtverteilungskurve (LVK) der Leuchte. Insbesondere kann ein Blendeffekt oder Spotlight-Effekt der Leuchte vermindert werden.

Die Direktlichtstruktur der Optik umfasst vorzugsweise einen Reflexionsbereich der Innenseite der Optik, der in einem flachen Winkel vom LED-Leuchtmittel abgestrahltes Licht in den Zentralbereich der Aussenseite der Optik leitet. Der Begriff "flacher Winkel" im Zusammenhang mit dem LED-Leuchtmittel kann sich auf einen Raumwinkel beziehen, der im Vergleich zu einer Hauptabstrahlungsrichtung des LED-Leuchtmittels flach ist. Insbesondere kann er sich auf einen spitzen Winkel zwischen der Abstrahlrichtung des LED-Leuchtmittels und der Montageoberfläche der Platine beziehen. Ein solcher spitzer Winkel kann beispielsweise kleiner als 30°, kleiner als 20°, kleiner als 15° oder kleiner als 10° sein. In anderen Worten ist der flache Winkel des vom LED-Leuchtmittel abgestrahlten Lichts ein Winkel, der gemessen zur Hauptabstrahlungsrichtung gross ist, jedoch typischerweise 90° gemessen zur Hauptabstrahlungsrichtung nicht übersteigt. Er kann also gemessen zur Hauptabstrahlungsrichtung beispielsweise grösser 60° und kleiner als 90° oder grösser 70° und kleiner als 90° oder grösser 75° und kleiner als 90° oder grösser 80° und kleiner als 90° sein.

Heutige Leuchtdioden und insbesondere phosphorvergusskonvertierte Leuchtdioden weisen eine Farbverschiebung über ihren Abstrahlungswinkelbereich auf. Dabei ist das in einem verhältnismässig flachen oder kleinen Winkel abgestrahlte Licht typischerweise eher gelb und das in einem grossen Winkel also gegen die Hauptabstrahlungsrichtung abgestrahlte Licht eher blau. Mit der Umleitung des in einem flachen Winkel abgestrahlten Lichts in den Zentralbereich kann einerseits verhindert werden, dass das eher gelbliche Licht das Lichtbild der Leuchte stört und andererseits kann es mit dem eher blauen Licht gemischt werden, wodurch eine homogenere Lichtfarbe im Lichtbild der Leuchte erzeugt werden kann.

Der Reflexionsbereich der Aussenseite der Optik umgibt vorzugsweise den Zentralbereich der Aussenseite der Optik. So kann eine gleichmässige Abstrahlung und eine bevorzugte LVK erreicht werden. Dabei umfasst die Direktlichtstruktur der Optik vorzugsweise einen Peripherbereich der Aussenseite der Optik, der den Reflexionsbereich der Aussenseite der Optik umgibt. Durch den Peripherbereich der Aussenseite der Optik kann insbesondere Licht austreten, das in einem Winkel vom LED-Leuchtmittel abgestrahlt wird, der grösser als der zu einer Umlenkung am Reflexionsbereich der Innenseite der Optik führende Winkel und kleiner als der zu einer Umlenkung am Reflexionsbereich der Aussenseite der Optik führende Winkel ist.

Bevorzugt weist die Optik eine Diffuslichtstruktur auf, die einen Randbereich der Aussenseite der Optik umfasst, wobei die Diffuslichtstruktur der Optik einen von der Platine reflektierten Teil des Indirektlichtanteils des vom LED-Leuchtmittel abgestrahlten Lichts an den Randbereich der Aussenseite der Optik leitet. Mit einer solchen Diffuslichtstruktur kann das Direktlicht des LED-Leuchtmittels über die Leuchte nivelliert werden. Dies ermöglicht, dass die Leuchte weniger Lichtkontraste aufweist, was für einen Betrachter als angenehm empfunden werden kann. Die LVK der Leuchte kann so bevorzugt angepasst werden.

Bei der Ausgestaltung der Leuchte mit der Diffuslichtstruktur kann insbesondere die Platine aus Aluminium oder einem anderen geeigneten gut reflektierenden Material hergestellt, beschichtet oder abgedeckt sein. So kann das Diffuslicht der Leuchte verbessert eingestellt werden.

Vorzugsweise umfasst die Indirektlichtstruktur der Optik einen Reflexionsaustrittsbereich an der Innenseite der Optik, der an die durchgehende Öffnung der Platine angrenzt. Ein solcher Reflexionsaustrittsbereich ermöglicht es, reflektiertes Licht von der Innenseite der Optik abzustrahlen. Dabei weist der Reflexionsaustrittsbereich vorzugsweise eine Kontur auf, mit der eine Lichtverteilungskurve des via dem Reflexionsaustrittsbereich durch die durchgehende Öffnung der Platine austretenden Indirektlichtanteils des vom LED-Leuchtmittel abgestrahlten Lichts eingestellt wird. Die Kontur kann insbesondere an der Innenseite der Optik ausgebildete Wellen und/oder Prismen, Facetten, Mikrostrukturen, Nanostrukturen oder dergleichen umfassen. Ein solcher Reflexionsaustrittsbereich ermöglicht eine effiziente Einstellung des die Öffnung der Platine durchdringenden Lichts.

Der Reflexionsaustrittsbereich kann in der Ebene der Montageoberfläche der Platine liegen. Vorzugsweise erstreckt er sich jedoch in die durchgehende Öffnung der Platine hinein. Dabei kann er auch die Öffnung der Platine durchragen. Eine solche Ausgestaltung ermöglicht eine freiere Gestaltung der Kontur des Reflexionsaustrittsbereichs, wodurch die zugehörigen Abstrahlcharakteristika verbessert eingestellt werden können. Zudem ermöglicht eine solche Ausgestaltung, dass die Optik bezüglich des LED-Leuchtmittels zentriert beziehungsweise exakt positioniert und ausgerichtet wird.

Die Optik und die Platine können auch mit weiteren Mitteln ausgestattet sein, die eine zusätzliche Zentrierung beziehungsweise Ausrichtung und Positionierung ermöglichen. Beispielsweise kann die Optik Dome oder Zylinder an seiner Innenseite und die Platine korrespondierende Bohrungen aufweisen. Die Optik wird dann beim Zusammenbau zusätzlich zentriert beziehungsweise positioniert und ausgerichtet, indem die Dome in die Bohrungen eingreifen.

Bei der Positionierung und Ausrichtung der Optik zum LED-Leuchtmittel kann die Optik so angeordnet sein, dass das LED-Leuchtmittel in einer Symmetriereferenz und insbesondere in einer Symmetrieachse der Optik liegt. Eine solche Anordnung kann als "zentriert" bezeichnet werden. Sie ermöglicht eine gleichmässige vordefinierbare Abstrahlung von Licht. Alternativ dazu kann das LED-Leuchtmittel auch ausserhalb der Symmetriereferenz der Optik liegen, was eine asymmetrische vordefinierbare Abstrahlung von Licht aus der Leuchte ermöglicht. Je nach Anwendung der Leuchte kann ihre LVK also über die Positionierung und Ausrichtung der Optik zum LED-Leuchtmittel eingestellt werden.

Die durchgehende Öffnung der Platine ist ringsegmentförmig ausgestaltet, wobei das LED-Leuchtmittel mittig im Ringsegment der durchgehenden Öffnung montiert ist. Ringsegmentförmig kann in einer Aufsicht C-förmig sein. Eine solche Ausgestaltung der Öffnung in der Platine ermöglicht zum einen eine effiziente und ästhetisch ansprechende Durchführung von Licht auf die Rückseite der Platine. Zum anderen wird eine Wärmeabfuhr über den Steg des Ringsegments ermöglicht, was für den Betrieb des LED-Leuchtmittels wichtig sein kann.

Vorzugsweise sind bei der Leuchte eine Mehrzahl von LED-Leuchtmitteln auf der Montageoberfläche der Platine montiert, die von einer Mehrzahl von identischen Optiken abgedeckt sind, wobei jeweils eine der Optiken eines der LED-Leuchtmittel abdeckt. Eine solche Ausgestaltung der Leuchte ermöglicht es eine grössere Fläche sowohl im Vorderraum als auch im Rückraum zu beleuchten.

Die Mehrzahl von Optiken kann identische Optiken umfassen, welche die LED-Leuchtmittel in identischer Weise abdecken. Sie kann auch identische Optiken umfassen, welche die LED-Leuchtmittel in verdrehter oder versetzter Weise abdecken. Weiter kann sie unterschiedliche Optiken umfassen. Auch eine Kombination der vorstehenden Varianten von Optiken kann von der Mehrzahl von Optiken umfasst sein. Auf diese Weise kann die LVK der Leuchte äusserst flexibel auf den Einsatzzweck der Leuchte hin angepasst werden.

Dabei ist die Mehrzahl von Optiken vorzugsweise einstückig ausgebildet. Eine solche einstückige Ausgestaltung ermöglicht eine verhältnismässig einfache und effiziente Montage beziehungsweise Fertigung der Leuchte.

Weiter weist dabei die Platine bevorzugt eine Mehrzahl von ringsegmentförmigen durchgehenden Öffnungen auf, wobei jeweils eines der Mehrzahl von LED-Leuchtmittel im Ringsegment einer der Mehrzahl von durchgehenden Öffnungen montiert ist und wobei die Ringsegmente benachbarter durchgehender Öffnungen zueinander verdreht sind. Eine solche Anordnung der ringsegmentförmigen Öffnungen ermöglicht eine gleichmässige Lichtverteilung und ein ästhetisch ansprechendes Erscheinungsbild der Leuchte.

### Kurze Beschreibung der Zeichnungen

Weitere vorteilhafte Ausgestaltungen der Erfindung ergeben sich aus der nachfolgenden Beschreibung von Ausführungsbeispielen mithilfe der schematischen Zeichnungen.

Insbesondere wird im Folgenden die erfindungsgemässe Leuchte unter Bezugnahme auf die beigefügten Zeichnungen anhand von Ausführungsbeispielen detaillierter beschrieben. Es zeigen:
- Fig. 1: eine Querschnittsansicht eines Teils eines Ausführungsbeispiels einer erfindungsgemässen Leuchte;
- Fig. 2: eine Ansicht an einen Teil einer Linsenanordnung mit mehreren Linsen der Leuchte von Fig. 1;
- Fig. 3: eine Ansicht an einen Teil eines Trägers der Leuchte von Fig. 1; und
- Fig. 4: eine Lichtverteilungskurve der Leuchte von Fig. 1.

### Weg(e) zur Ausführung der Erfindung

Bestimmte Ausdrücke werden in der folgenden Beschreibung aus praktischen Gründen verwendet und sind nicht einschränkend zu verstehen. Die Wörter "rechts", "links", "unten" und "oben" bezeichnen Richtungen in der Zeichnung, auf die Bezug genommen wird. Die Ausdrücke "nach innen", "nach aussen" "unterhalb", "oberhalb", "links", "rechts" oder ähnliche werden zur Beschreibung der Anordnung bezeichneter Teile zueinander, der Bewegung bezeichneter Teile zueinander und der Richtungen hin zum oder weg vom geometrischen Mittelpunkt der Erfindung sowie benannter Teile derselben verwendet wie sie in den Fig. dargestellt sind. Diese räumlichen Relativangaben umfassen auch andere Positionen und Ausrichtungen als die in den Fig. dargestellten. Zum Beispiel wenn ein in den Fig. dargestelltes Teil umgedreht wird, sind Elemente oder Merkmale, die als "unterhalb" beschrieben sind, dann "oberhalb". Die Terminologie umfasst die oben ausdrücklich erwähnten Wörter, Ableitungen von denselben und Wörter ähnlicher Bedeutung.

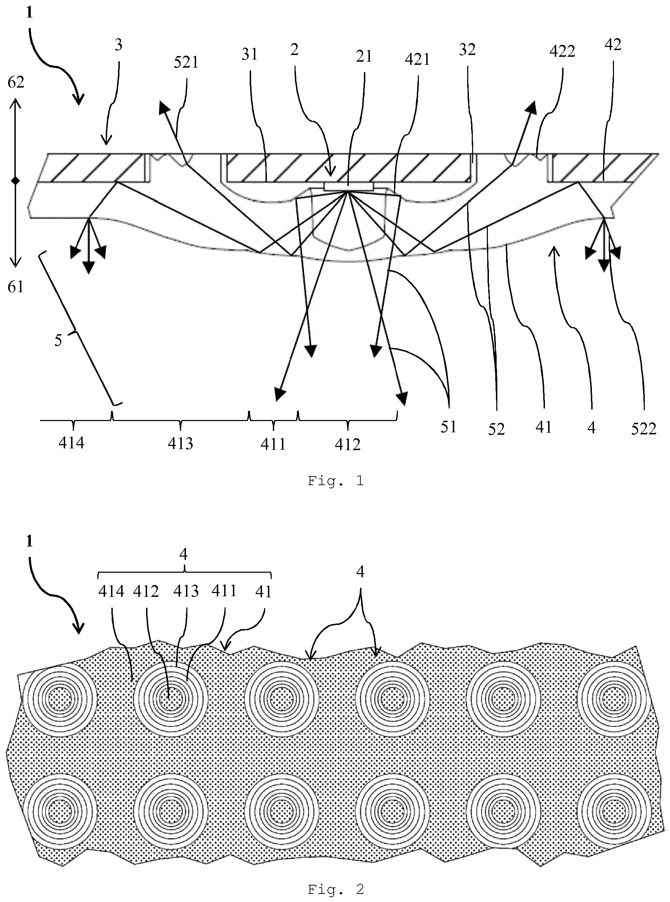

Fig. 1 zeigt ausgewählte Bauteile einer Pendelleuchte 1 als Ausführungsbeispiel einer erfindungsgemässen Leuchte. Neben den in der Fig. 1 gezeigten Bauteilen enthält die Pendelleuchte 1 weitere Bauteile wie beispielsweise ein Gehäuse oder eine Aufhängeeinrichtung. Diese weiteren Bauteile sind jedoch für die vorliegende Erfindung von untergeordneter Bedeutung und deshalb in den Fig. nicht dargestellt.

Die Pendelleuchte 1 umfasst eine Platine 3, eine Vielzahl von LED-Leuchtmitteln 2 und eine einteilige Linsenanordnung aus einem transparenten Kunststoff mit einer Vielzahl von Linsen 4 als Optiken. Zur besseren Übersichtlichkeit ist in der Fig. 1 ein Einzelnes der LED-Leuchtmittel 2 und eine Einzelne der Linsen 4 der Linsenanordnung dargestellt. Entsprechend ist im nachfolgenden zugehörigen Text dieses Einzelne der LED-Leuchtmittel 2 und diese Einzelne der Linsen 4 beschrieben. Die weiteren der LED-Leuchtmittel 2 und der Linsen 4 sind analog ausgestaltet.

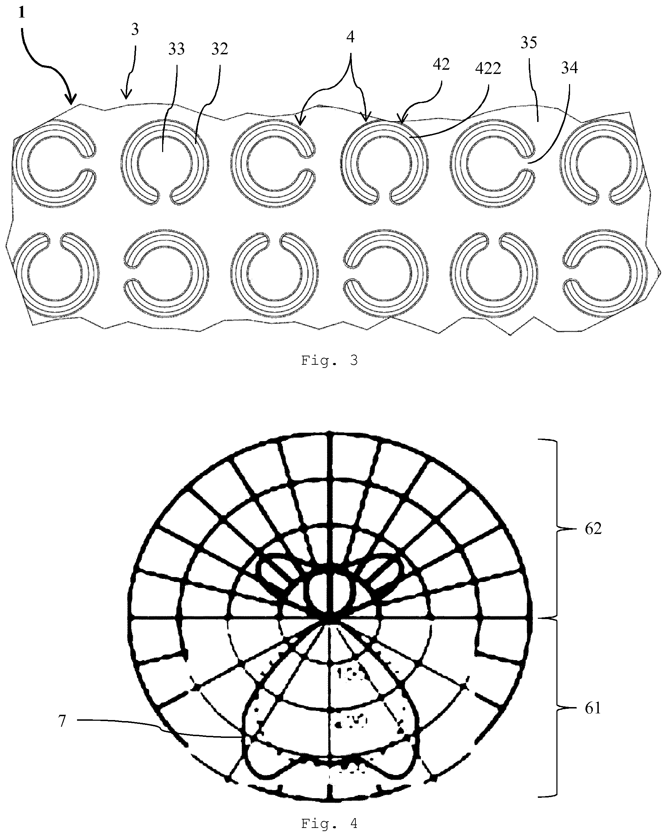

Das LED-Leuchtmittel 2 weist eine Leuchtdiode 21 auf, die auf einer Montageoberfläche 31 der Platine 3 montiert ist. Die Montageoberfläche 31 ist dabei an einer Unterseite der Platine 3 ausgebildet. Die Platine 3 weist weiter eine durchgehende Öffnung 32 auf. Die Leuchtdiode 21 des LED-Leuchtmittels 2 ist mittig in der Öffnung 32 der Platine 3 angeordnet. Die Form und Ausgestaltung der Öffnung 32 ist weiter unten im Zusammenhang mit der Fig. 3 detaillierter beschrieben. Die Platine 3 ist zum Beispiel aus Aluminium hergestellt.

Die Linse 4 weist eine der Platine 3 abgewandte Aussenseite 41 und eine der Platine 3 zugewandte Innenseite 42 auf. Die Aussenseite 41 der Linse 4 umfasst einen gerade unterhalb der Leuchtdiode 21 angeordneten Zentralbereich 412, einen den Zentralbereich 412 umgebenden Reflexionsbereich 411, einen den Reflexionsbereich 411 umgebenden Peripherbereich 413 und einen den Peripherbereich 413 umgebenden Randbereich 414. Die Innenseite 42 der Linse 4 umfasst einen die Leuchtdiode 21 umgebenden Reflexionsbereich 421 und einen in die Öffnung 32 der Platine 3 hineinragenden Reflexionsaustrittsbereich 422. Der Reflexionsaustrittsbereich 422 ist mit einer Prismen umfassenden Kontur ausgebildet.

Die Leuchtdiode 21 des LED-Leuchtmittels 2 ist von der Platine 3 aus nach unten gerichtet. Das heisst, sie strahlt Licht 5 mit einer vertikal nach unten verlaufenden Hauptabstrahlungsrichtung ab. Insbesondere wird das Licht 5 vom LED-Leuchtmittel 2 über einen bestimmten Winkelbereich abgestrahlt. Dabei hat das in einem flachen Winkel abgestrahlte Licht 5 ein eher gelbliches Spektrum und das in einem spitzen Winkel zur Hauptabstrahlungsrichtung also quasi in der Hauptabstrahlungsrichtung abgestrahlte Licht 5 ein eher bläuliches Spektrum.

Ein Direktlichtanteil 51 des vom LED-Leuchtmittel 2 abgestrahlten Lichts 5 wird von einer Direktlichtstruktur der Linse 4 auf den Zentralbereich 412 der Aussenseite 41 geleitet und von dort aus von der Pendelleuchte 1 abgestrahlt. Der Direktlichtanteil 51 umfasst dabei einerseits vom LED-Leuchtmittel 2 abgestrahltes Licht 5, das gerade beziehungsweise direkt von der Leuchtdiode 21 in Richtung des Zentralbereichs 412 abgestrahlt wird. Dieses vom LED-Leuchtmittel 2 abgestrahlte Licht 5 weist einen verhältnismässig spitzen Abstrahlungswinkel zur Hauptabstrahlungsrichtung auf und ist somit eher bläulich. Andererseits umfasst der Direktlichtanteil 51 Licht 5 das von der Leuchtdiode 21 auf den Reflexionsbereich 421 an der Innenseite 42 der Linse 4 auftrifft und von diesem in den Zentralbereich 412 der Aussenseite 41 der Linse 4 umgeleitet wird. Dieses vom LED-Leuchtmittel 2 abgestrahlte Licht 5 weist einen verhältnismässig flachen Abstrahlungswinkel auf und ist somit eher gelblich.

Der Direktlichtanteil 51 des vom LED-Leuchtmittel 2 abgestrahlten Lichts 5 weist also ursprünglich eher gelbliche und eher bläuliche Anteile auf, die gemischt werden. Damit werden die Farbverschiebungen des vom LED-Leuchtmittel 2 abgestrahlten Lichts 5 im Direktlichtanteil 51 ausgeglichen. Der Reflexionsbereich 421 der Innenseite 42 und der Zentralbereich 412 der Aussenseite 41 sind von der Direktlichtstruktur der Linse 4 umfasst.

Ein Indirektlichtanteil 52 des vom LED-Leuchtmittel 2 abgestrahlten Lichts 5 wird vom Reflexionsbereich 411 der Aussenseite 41 der Linse 4 reflektiert beziehungsweise umgeleitet. Der Indirektlichtanteil 52 umfasst dabei im Wesentlichen alles vom LED-Leuchtmittel 2 abgestrahlte Licht 5, das nicht im Direktlichtanteil 51 enthalten ist. Der Direktlichtanteil 51 umfasst etwa 70% des vom LED-Leuchtmittel 2 abgestrahlten Lichts 5 und der Indirektlichtanteil 52 etwa 30%.

Der vom Reflexionsbereich 411 der Aussenseite 41 der Linse 4 umgeleitete Indirektlichtanteil 52 trifft einerseits auf den Reflexionsaustrittsbereich 422 der Innenseite 42 der Linse 4 und wird von dort als Rücklicht 521 von der Pendelleuchte 1 abgestrahlt. Über die die Prismen umfassende Kontur des Reflexionsaustrittsbereichs 422 wird die Charakteristik des Rücklichts 521 festgelegt. Der Reflexionsbereich 411 der Aussenseite 41 und der Reflexionsaustrittsbereich 422 der Innenseite 42 sind von einer Indirektlichtstruktur der Linse 4 umfasst.

Andererseits trifft der vom Reflexionsbereich 411 der Aussenseite 41 umgeleitete Indirektlichtanteil 52 auf die Montageoberfläche 31 der Platine 3, wird von dieser wiederum reflektiert und über den Randbereich 414 der Aussenseite 41 der Linse 4 als Diffuslicht 522 von der Pendelleuchte 1 abgestrahlt. Mit dem Diffuslicht 522 wird die Leuchtfläche der Leuchte 1 als Ganzes zum Leuchten gebracht, was zu einer Nivellierung des Direktlichtanteils 51 führt. Dadurch ergeben sich für das menschliche Auge geringere Lichtkontraste beim Anschauen der Leuchtfläche der Pendelleuchte 1, was typischerweise als angenehm und weniger ermüdend empfunden wird. Der Reflexionsbereich 411 der Aussenseite 41, der Peripherbereich 413 der Aussenseite 41 und der Randbereich 414 der Aussenseite 41 sind von einer Diffuslichtstruktur der Linse 4 umfasst.

Die Pendelleuchte 1 weist eine vertikal abwärts verlaufende Primärabstrahlungsrichtung 61 auf, in die der Direktlichtanteil 51 des vom LED-Leuchtmittel 2 abgestrahlten Lichts 5 und das Diffuslicht 522 abgestrahlt wird. In die Primärabstrahlungsrichtung 61 beleuchtet die Pendelleuchte 1 einen Vorderraum der Pendelleuchte 1. Zusätzlich weist die Leuchte 1 eine Sekundärabstrahlungsrichtung 62 auf, in die insbesondere das Rücklicht 521 abgestrahlt wird. In die Sekundärabstrahlungsrichtung 62 beleuchtet die Pendelleuchte 1 einen Rückraum der Pendelleuchte 1.

Die Ausgestaltung der Pendelleuchte 1 mit einer Platine 3 mit durchgehenden Öffnungen 32 und der Linsenanordnung mit den Linsen 4 ermöglicht, dass die Platine 3 nur einseitig mit Leuchtdioden 21 bestückt ist und trotzdem der Rückraum der Pendelleuchte 1 beleuchtet werden kann. Dies erlaubt eine verhältnismässig geringe Aufbauhöhe der Pendelleuchte 1 und einen verhältnismässig geringen Bedarf an Bauteilen.

Um Wiederholungen in den Fig. und der zugehörigen Beschreibung der verschiedenen Aspekte und Ausführungsbeispielen zu vermeiden, sollen bestimmte Merkmale als gemeinsam für verschieden Aspekte und Ausführungsbeispiele verstanden werden. Das Weglassen eines Aspekts in der Beschreibung oder einer Fig. lässt nicht darauf schliessen, dass dieser Aspekt in dem zugehörigen Ausführungsbeispiel fehlt. Vielmehr kann ein solches Weglassen der Klarheit und dem Verhindern von Wiederholungen dienen. In diesem Zusammenhang gilt für die gesamte weitere Beschreibung folgende Festlegung: Sind in einer Figur zum Zweck zeichnerischer Eindeutigkeit Bezugszeichen enthalten, aber im unmittelbar zugehörigen Beschreibungstext nicht erwähnt, so wird auf deren Erläuterung in vorangehenden Figurenbeschreibungen Bezug genommen. Sind ausserdem im unmittelbar zu einer Figur gehörigen Beschreibungstext Bezugszeichen erwähnt, die in der zugehörigen Figur nicht enthalten sind, so wird auf die vorangehenden und nachstehenden Figuren verwiesen. Ähnliche Bezugszeichen in zwei oder mehreren Fig. stehen für ähnliche oder gleiche Elemente.

In der Fig. 2 sind die Bauteile der Pendelleuchte 1 der Fig. 1 von unten her gezeigt. Darin ist ersichtlich, dass die Linsenanordnung einstückig mit mehreren Reihen von identischen Linsen 4 ausgebildet ist. Von unten her sind die Aussenseiten 41 der Linsen 4 sichtbar. Jede Linse 4 der Linsenanordnung ist einem LED-Leuchtmittel 2 (in Fig. 2 nicht ersichtlich) zugeordnet.

Die Zentralbereiche 412 der Aussenseiten 41 der Linsen 4 sind jeweils kreisförmig ausgestaltet. Die Reflexionsbereiche 411 sind jeweils ringförmig um einen der Zentralbereiche 412 herum und die Peripherbereiche 413 jeweils ringförmig um einen der Reflexionsbereiche 411 herum geformt. Um die Peripherbereiche 413 herum sind die Randbereiche 414 der Aussenseiten 41 der Linsen 4 angeordnet, wobei diese aneinander angrenzen und miteinander verbunden sind.

Die Zentralbereiche 412 und die Randbereiche 414 der Aussenseiten 41 der Linsen 4 sind mittels Erodieren, mittels Glasperlenstrahlen oder mittels einer sonstigen Mikrostrukturierungstechnik mattiert. Dadurch kann einerseits eine störende Direktsicht auf die phosphorgelben Leuchtdioden 21 vermieden und andererseits eine sanft verlaufende Ästhetik bei der leuchtenden Pendelleuchte 1 ermöglicht werden. Die Bereiche der Aussenseiten 41 und der Innenseiten 42 der Linsen 4, die reflektierende Eigenschaften aufweisen, sind poliert, um eine möglichst ideale Reflexion zu ermöglichen.

Die Vereinigung der Mehrzahl von Linsen 4 in der Linsenanordnung ermöglicht eine effiziente Realisierung beispielsweise im Spritzguss. Zudem erlaubt dies auch eine effiziente Montage, wobei die Linsenanordnung beispielsweise über vier bis acht Schrauben oder über ein Einschieben in ein umlaufendes Profil befestigt werden kann.

Fig. 3 zeigt die Bauteile der Pendelleuchte 1 der Fig. 1 von oben her. Darin ist ersichtlich, dass die durchgehenden Öffnungen 32 der Platine 3 analog zu den Linsen 4 der Linsenanordnung in mehreren Reihen angeordnet sind. Die Öffnungen 32 sind ringsegmentförmig oder C-förmig ausgestaltet. Innerhalb der Ringsegmente der Öffnungen 32 ist jeweils ein kreisförmiger Inselabschnitt 33 beziehungsweise Halbinselabschnitt der Platine 3 angeordnet, an dessen Unterseite die Leuchtdiode 21 einer der LED-Leuchtmittel 2 montiert ist.

Die Inselabschnitte 33 sind jeweils über einen Steg 34 mit einem Grundabschnitt 35 der Platine 3 verbunden. Die Stege 34 dienen einerseits dazu, die Inselabschnitte 33 zu tragen und andererseits Wärme von den Leuchtdioden 21 abzuführen. Benachbarte Öffnungen 32 sind jeweils um 90° zueinander verdreht. Dadurch kann ein gleichmässiges Lichtbild im Rückraum der Pendelleuchte 1 erreicht werden. Die benachbarten Öffnungen 32 können auch in beliebigen anderen Winkeln wie beispielsweise im Winkel der Stegbreite zueinander verdreht sein.

Die Reflexionsaustrittsbereiche 422 der Innenseiten 42 der Linsen 4 sind analog zu den Öffnungen 32 der Platine 3 ringsegmentförmig oder C-förmig ausgestaltet. Indem sie sich jeweils in eine der Öffnungen 32 hinein erstrecken, werden die Linsen 4 exakt zu den LED-Leuchtmitteln 2 positioniert und ausgerichtet. Zusätzlich kann die Linsenanordnung zum gleichen Zweck auch noch Zentrierdome aufweisen (in den Fig. nicht dargestellt).

In Fig. 4 ist eine Lichtverteilungskurve (LVK) 7 der Pendelleuchte 1 gezeigt. Darin ist ersichtlich, dass die LVK 7 einen Abschnitt in die Primärabstrahlungsrichtung 61 und einen in die Sekundärabstrahlungsrichtung 62 aufweist.

Der Abschnitt der LVK 7 in die Sekundärabstrahlungsrichtung 62 wird insbesondere vom Rücklicht 521 der Pendelleuchte 1 gebildet. Er wird durch die Kontur der Reflexionsaustrittsbereiche 422 der Innenseiten 42 der Linsen 4 definiert.

Der Abschnitt der LVK 7 in die Primärabstrahlungsrichtung 61 wird insbesondere vom Direktlichtanteil 51 und vom Diffuslicht 522 der Pendelleuchte 1 gebildet. Er wird durch die Beschaffenheit der Zentralbereiche 412 und der Randbereiche 414 Aussenseiten 41 der Linsen 4 definiert.

Obwohl die Erfindung mittels der Figuren und der zugehörigen Beschreibung dargestellt und detailliert beschrieben ist, sind diese Darstellung und diese detaillierte Beschreibung illustrativ und beispielhaft zu verstehen und nicht als die Erfindung einschränkend. Um die Erfindung nicht zu verklären, können in gewissen Fällen wohlbekannte Strukturen und Techniken nicht im Detail gezeigt und beschrieben sein. Es versteht sich, dass Fachleute Änderungen und Abwandlungen machen können, ohne den Umfang der folgenden Ansprüche zu verlassen. Insbesondere deckt die vorliegende Erfindung weitere Ausführungsbeispiele mit irgendwelchen Kombinationen von Merkmalen ab, die von den explizit beschriebenen Merkmalskombinationen abweichen können. Beispielsweise kann die Erfindung auch in folgender Form realisiert sein:
- Die in den Fig. gezeigten Bauteile können in analoger Weise auch in anderen Leuchten als in Pendelleuchten wie beispielsweise in Steh-, Wand- oder Deckenleuchten eingesetzt werden.
- Die in den Fig. gezeigten oder ähnliche Bauteile können auch in um 180° gedrehter Anordnung eingesetzt werden. In einer solchen Ausführung wird das Rücklicht in Primärabstrahlungsrichtung zur Beleuchtung des Vorderraums und das Diffuslicht und das Direktlicht in Sekundärabstrahlungsrichtung zur Beleuchtung des Rückraums eingesetzt werden. Dabei kann über eine geeignete Ausgestaltung der Linsen der Direktlichtanteil und der Indirektlichtanteil der Pendelleuchte passend eingestellt werden.
- In der vorstehend erwähnten gedrehten Ausführung sind die Zentralbereiche und die Randbereiche der Aussenseiten der Linsen vorzugsweise nicht mattiert.

Die vorliegende Offenbarung umfasst auch Ausführungsformen mit jeglicher Kombination von Merkmalen, die vorstehend oder nachfolgend zu verschiedenen Ausführungsformen genannt oder gezeigt sind. Sie umfasst ebenfalls einzelne Merkmale in den Figuren, auch wenn sie dort im Zusammenhang mit anderen Merkmalen gezeigt sind und/oder vorstehend oder nachfolgend nicht genannt sind. Auch können die in den Figuren und der Beschreibung beschriebenen Alternativen von Ausführungsformen und einzelne Alternativen von deren Merkmalen vom Erfindungsgegenstand beziehungsweise von den offenbarten Gegenständen ausgeschlossen sein. Die Offenbarung umfasst Ausführungsformen, die ausschliesslich die in den Ansprüchen beziehungsweise in den Ausführungsbeispielen beschriebenen Merkmale umfassen sowie auch solche, die zusätzliche andere Merkmale umfassen. Im Weiteren schliesst der Ausdruck "umfassen" und Ableitungen davon andere Elemente oder Schritte nicht aus. Ebenfalls schliesst der unbestimmte Artikel "ein" bzw. "eine" und Ableitungen davon eine Vielzahl nicht aus. Die Funktionen mehrerer in den Ansprüchen aufgeführter Merkmale können durch eine Einheit beziehungsweise einen Schritt erfüllt sein. Die Begriffe "im Wesentlichen", "etwa", "quasi" "ungefähr" und dergleichen in Verbindung mit einer Eigenschaft beziehungsweise einem Wert definieren insbesondere auch genau die Eigenschaft beziehungsweise genau den Wert. Die Begriffe "etwa", "quasi" und "ungefähr" im Zusammenhang mit einem gegebenen Zahlenwert oder - bereich kann sich auf einen Wert beziehungsweise Bereich beziehen, der innerhalb 20%, innerhalb 10%, innerhalb 5% oder innerhalb 2% des gegebenen Werts beziehungsweise Bereichs liegt. Alle Bezugszeichen in den Ansprüchen sind nicht als den Umfang der Ansprüche einschränkend zu verstehen.

## Patentansprüche

1. Leuchte (1) mit einer Primärabstrahlungsrichtung (61) zur Beleuchtung eines Vorderraums der Leuchte (1) und einer der Primärabstrahlungsrichtung (61) im Wesentlichen entgegengesetzten Sekundärabstrahlungsrichtung (62) zur Beleuchtung eines Rückraums der Leuchte (1), umfassend
eine Platine (3) mit einer Montageoberfläche (31),
ein auf der Montageoberfläche (31) der Platine (3) montiertes LED-Leuchtmittel (2) und
eine das LED-Leuchtmittel (2) abdeckende Optik (4) mit einer der Platine (3) zugewandten Innenseite (42) und einer der Platine (3) abgewandten Aussenseite (41), wobei
die Optik (4) eine Direktlichtstruktur (412, 421) und eine Indirektlichtstruktur (411, 422) aufweist,
die Direktlichtstruktur (412, 421) einen Direktlichtanteil (51) von vom LED-Leuchtmittel (2) abgestrahltem Licht (5) an die Aussenseite (41) der Optik (4) leitet,
die Indirektlichtstruktur (411, 422) einen Indirektlichtanteil (52) des vom LED-Leuchtmittel (2) abgestrahlten Lichts (5) an die Innenseite (42) der Optik (4) leitet, und
die Platine (3) in einem Bereich, an dem der Indirektlichtanteil (52) des vom LED-Leuchtmittel (2) abgestrahlten Lichts (5) auf eine Ebene der Montageoberfläche (31) der Platine (3) auftritt, eine durchgehende Öffnung (32) aufweist,
**dadurch gekennzeichnet, dass**
die durchgehende Öffnung (32) der Platine (3) ringsegmentförmig ausgestaltet ist, wobei das LED-Leuchtmittel (2) mittig im Ringsegment der durchgehenden Öffnung (32) montiert ist.

2. Leuchte (1) nach Anspruch 1, bei der die Indirektlichtstruktur (411, 422) der Optik (4) einen Reflexionsbereich (411) der Aussenseite (41) der Optik (4) umfasst, der so geformt ist, dass bezüglich des vom LED-Leuchtmittel (2) abgestrahlten Lichts (5) Totalreflexion auftritt.

3. Leuchte (1) nach Anspruch 1 oder 2, bei der die Direktlichtstruktur (412, 421) der Optik (4) einen Zentralbereich (412) der Aussenseite (41) der Optik (4) umfasst, der zentral benachbart zum LED-Leuchtmittel (2) angeordnet ist.

4. Leuchte (1) nach Anspruch 3, bei welcher der Zentralbereich (412) der Aussenseite (41) der Optik (4) getrübt ist.

5. Leuchte (1) nach Anspruch 3 oder 4, bei der die Direktlichtstruktur (412, 421) der Optik (4) einen Reflexionsbereich (421) der Innenseite (42) der Optik (4) umfasst, der in einem flachen Winkel vom LED-Leuchtmittel (2) abgestrahltes Licht (5) in den Zentralbereich (412) der Aussenseite (41) der Optik (4) leitet.

6. Leuchte (1) nach Anspruch 2 und einem der Ansprüche 3 bis 5, bei welcher der Reflexionsbereich (411) der Aussenseite (41) der Optik (4) den Zentralbereich (412) der Aussenseite (41) der Optik (4) umgibt.

7. Leuchte (1) nach Anspruch 6, bei der die Direktlichtstruktur (412, 421) der Optik (4) einen Peripherbereich (413) der Aussenseite (41) der Optik (4) umfasst, der den Reflexionsbereich (411) der Aussenseite (41) der Optik (4) umgibt.

8. Leuchte (1) nach einem der vorangehenden Ansprüche, bei der die Optik (4) eine Diffuslichtstruktur (411, 413, 414) aufweist, die einen Randbereich (414) der Aussenseite (41) der Optik (4) umfasst, wobei die Diffuslichtstruktur (411, 413, 414) der Optik (4) einen von der Platine (3) reflektierten Teil des Indirektlichtanteils (52) des vom LED-Leuchtmittel (2) abgestrahlten Lichts (5) an den Randbereich (414) der Aussenseite (41) der Optik (4) leitet.

9. Leuchte (1) nach einem der vorangehenden Ansprüche, bei der die Indirektlichtstruktur (411, 422) der Optik (4) einen Reflexionsaustrittsbereich (422) an der Innenseite (42) der Optik (4) umfasst, der an die durchgehende Öffnung (32) der Platine (3) angrenzt.

10. Leuchte (1) nach Anspruch 9, bei welcher der Reflexionsaustrittsbereich (422) der Innenseite (42) der Optik (4) eine Kontur oder eine Mikro- beziehungsweise Nanostruktur aufweist, mit der eine Lichtverteilungskurve (7) des via dem Reflexionsaustrittsbereich (422) durch die durchgehende Öffnung (32) der Platine (3) austretenden Indirektlichtanteils (52) des vom LED-Leuchtmittel (2) abgestrahlten Lichts (5) einstellbar ist.

11. Leuchte (1) nach Anspruch 9 oder 10, bei der sich der Reflexionsaustrittsbereich (422) der Innenseite (42) der Optik (4) in die durchgehende Öffnung (32) der Platine (3) hinein erstreckt.

12. Leuchte (1) nach einem der vorangehenden Ansprüche, bei der eine Mehrzahl von LED-Leuchtmitteln (2) auf der Montageoberfläche (31) der Platine (3) montiert sind, die von einer Mehrzahl von identischen Optiken (4) abgedeckt sind, wobei jeweils eine der Optiken (4) eines der LED-Leuchtmittel (2) abdeckt.

13. Leuchte (1) nach Anspruch 12, bei der die Mehrzahl von Optiken (4) einstückig ausgebildet ist.

14. Leuchte (1) nach Anspruch 12 oder 13, bei der die Platine (3) eine Mehrzahl von ringsegmentförmigen durchgehenden Öffnungen (32) aufweist, wobei jeweils eines der Mehrzahl von LED-Leuchtmittel (2) im Ringsegment einer der Mehrzahl von durchgehenden Öffnungen (32) montiert ist und wobei die Ringsegmente benachbarter durchgehender Öffnungen (32) zueinander verdreht sind.

## Claims

1. A luminaire (1) having a primary radiation direction (61) for the illumination of a front space of the luminaire (1) and a secondary radiation direction (62) substantially opposite the primary radiation direction (61) for illuminating a rear space of the luminaire (1), comprising
a printed circuit board (3) which has a mounting surface (31),
an LED lighting means (2) mounted on the mounting surface (31) of the printed circuit board (3) and
an optics (4) covering the LED lighting means (2) and comprising an internal side (42) facing the printed circuit board (3) and an external side (41) facing away from the printed circuit board (3), wherein
the optics (4) comprises a direct light structure (412, 421) and an indirect light structure (411, 422),
the direct light structure (412, 421) guides a direct light portion (51) of light (5) emitted by the LED lighting means (2) to the external side (41) of the optics (4),
the indirect light structure (411, 422) guides an indirect light portion (52) of the light (5) emitted by the LED lighting means (2) to the internal side (42) of the optics (4), and
the printed circuit board (3) comprises a continuous opening (32) in a region where the indirect light portion (52) of the light (5) emitted by the LED lighting means (2) is incident on a plane of the mounting surface (31) of the printed circuit board (3),
**characterised in that**
the continuous opening (32) of the printed circuit board (3) is designed in the shape of a ring segment, wherein the LED lighting means (2) is mounted in the middle in the ring segment of the continuous opening (32).

2. A luminaire (1) according to claim 1, wherein the indirect light structure (411, 422) of the optics (4) comprises a reflection region (411) of the external side (41) of the optics (4), which reflection region is shaped such that total reflection occurs with respect to the light (5) emitted by the LED lighting means (2).

3. A luminaire (1) according to claim 1 or 2, wherein the direct light structure (412, 421) of the optics (4) comprises a central region (412) of the external side (41) of the optics (4), which central region is arranged centrally adjacent to the LED lighting means (2).

4. A luminaire (1) according to claim 3, wherein the central region (412) of the external side (41) of the optics (4) is dulled.

5. A luminaire (1) according to claim 3 or 4, wherein the direct light structure (412, 421) of the optics (4) comprises a reflection region (421) of the internal side (42) of the optics (4) that guides light (5) emitted at a flat angle by the LED lighting means (2) to the central region (412) of the external side (41) of the optics (4).

6. A luminaire (1) according to claim 2 and any one of claims 3 to 5, wherein the reflection region (411) of the external side (41) of the optics (4) surrounds the central region (412) of the external side (41) of the optics (4).

7. A luminaire (1) according to claim 6, wherein the direct light structure (412, 421) of the optics (4) comprises a peripheral region (413) of the external side (41) of the optics (4), which peripheral region surrounds the reflection region (411) of the external side (41) of the optics (4).

8. A luminaire (1) according to any of the previous claims, wherein the optics (4) comprises a diffuse light structure (411, 413, 414) that comprises an edge region (414) of the external side (41) of the optics (4), wherein the diffuse light structure (411, 413, 414) of the optics (4) guides a part of the indirect light portion (52) of the light (5) emitted by the LED lighting means (2), said part of the indirect light portion being reflected from the printed circuit board (3), to the edge region (414) of the external side (41) of the optics (4).

9. A luminaire (1) according to any one of the previous claims, wherein the indirect light structure (411, 422) of the optics (4) comprises a reflection emission region (422) on the internal side (42) of the optics (4) that adjoins the continuous opening (32) of the printed circuit board (3).

10. A luminaire (1) according to claim 9, wherein the reflection emission region (422) of the internal side (42) of the optics (4) comprises a contour or a micro- or nano-structure with which a light distribution curve (7) of the indirect light portion (52) of the light (5) emitted by the LED lighting means (2) is adjustable, said indirect light portion being emitted via the reflection emission region (422) through the continuous opening (32) of the printed circuit board (3).

11. A luminaire (1) according to claim 9 or 10, wherein the reflection emission region (422) of the internal side (42) of the optics (4) extends into the continuous opening (32) of the printed circuit board (3).

12. A luminaire (1) according to any one of the previous claims, wherein a plurality of LED lighting means (2) are installed on the mounting surface (31) of the printed circuit board (3), said LED lighting means being covered by a plurality of identical optics (4), wherein each of the optics (4) covers one of the LED lighting means (2).

13. A luminaire (1) according to claim 12, wherein the plurality of optics (4) are formed in one piece.

14. A luminaire (1) according to claim 12 or 13, wherein the printed circuit board (3) comprises a plurality of ring-segment-shaped continuous openings (32), wherein each of the plurality of LED lighting means (2) in the ring segment is mounted on one of the plurality of continuous openings (32) and wherein the ring segments of adjacent continuous openings (32) are twisted towards one another.

## Revendications

1. Luminaire (1) avec une direction de rayonnement principale (61) pour l'éclairage d'un espace avant du luminaire (1) et une direction de rayonnement secondaire (62) disposée essentiellement à l'opposé de la direction de rayonnement principale (61) pour l'éclairage d'un espace arrière du luminaire (1), comprenant
un circuit imprimé (3) avec une surface de montage (31),
un moyen d'éclairage à DEL (2) monté sur la surface de montage (31) du circuit imprimé (3) et
une optique (4) recouvrant le moyen d'éclairage à DEL (2) avec une face interne (42) orientée vers le circuit imprimé (3) et une face externe (41) orientée à l'opposé du circuit imprimé (3),
l'optique (4) présentant une structure à lumière directe (412, 421) et une structure à lumière indirecte (411, 422),
la structure à lumière directe (412, 421) dirigeant une partie de la lumière directe (51) de la lumière (5) rayonnée par le moyen d'éclairage à DEL (2) vers la face externe (41) de l'optique (4),
la structure à lumière indirecte (411, 422) dirigeant une partie de la lumière indirecte (52) de la lumière (5) rayonnée par le moyen d'éclairage à DEL (2) vers la face interne (42) de l'optique (4) et
le circuit imprimé (3) présentant, dans une zone, sur laquelle la partie de lumière indirecte (52) de la lumière (5) rayonnée par le moyen d'éclairage à DEL (2) est incidente sur un plan de la surface de montage (31) du circuit imprimé (3), une ouverture traversante (32),
**caractérisée en ce que**
l'ouverture traversante (32) du circuit imprimé (3) est conçue en forme de segment de cercle, le moyen d'éclairage à DEL (2) étant monté au milieu du segment de cercle de l'ouverture traversante (32) .

2. Luminaire (1) selon la revendication 1, dans lequel la structure à lumière indirecte (411, 422) de l'optique (4) comprend une zone réfléchissante (411) de la face externe (41) de l'optique (4), qui est formée de manière à ce qu'une réflexion totale se produise par rapport à la lumière (5) rayonnée par le moyen d'éclairage à DEL (2).

3. Luminaire (1) selon la revendication 1 ou 2, dans lequel la structure à lumière directe (412, 421) de l'optique (4) comprend une zone centrale (412) de la face externe (41) de l'optique (4), qui est placée de manière centrale à côté du moyen d'éclairage à DEL (2).

4. Luminaire (1) selon la revendication 3, dans lequel la zone centrale (412) de la face externe (41) de l'optique (4) est trouble.

5. Luminaire (1) selon la revendication 3 ou 4, dans lequel la structure à lumière directe (412, 421) de l'optique (4) comprend une zone réfléchissante (421) de la face interne (42) de l'optique (4), qui dirige la lumière (5) rayonnée par le moyen d'éclairage à DEL (2) formant un angle plat dans la zone centrale (412) de la face externe (41) de l'optique (4).

6. Luminaire (1) selon la revendication 2 et l'une des revendications 3 à 5, dans lequel la zone réfléchissante (411) de la face externe (41) de l'optique (4) entoure la zone centrale (412) de la face externe (41) de l'optique (4) .

7. Luminaire (1) selon la revendication 6, dans lequel la structure à lumière directe (412, 421) de l'optique (4) comprend une zone périphérique (413) de la face externe (41) de l'optique (4), qui entoure la zone réfléchissante (411) de la face externe (41) de l'optique (4).

8. Luminaire (1) selon l'une des revendications précédentes, dans lequel l'optique (4) présente une structure à lumière diffuse (411, 413, 414), qui comprend une zone de bordure (414) de la face externe (41) de l'optique (4), la structure à lumière diffuse (411, 413, 414) de l'optique (4) dirigeant une partie réfléchie, depuis le circuit imprimé (3), de la partie de lumière indirecte (52) de la lumière (5) rayonnée par le moyen d'éclairage à DEL (2) vers la zone de bordure (414) de la face externe (41) de l'optique (4).

9. Luminaire (1) selon l'une des revendications précédentes, dans lequel la structure à lumière indirecte (411, 422) de l'optique (4) comprend une zone d'incidence de réflexion (422) sur la face interne (42) de l'optique (4), qui jouxte l'ouverture traversante (32) du circuit imprimé (3).

10. Luminaire (1) selon la revendication 9, dans lequel la zone d'incidence de réflexion (422) de la face interne (42) de l'optique (4) présente un profil ou une micro- ou nanostructure, avec laquelle une courbe de répartition de la lumière (7) de la partie de lumière indirecte (52) de la lumière (5) rayonnée par le moyen d'éclairage à DEL (2) incidente par le biais de la zone d'incidence de réflexion (422) à travers l'ouverture traversante (32) du circuit imprimé (3) peut être réglée.

11. Luminaire (1) selon la revendication 9 ou 10, dans lequel la zone d'incidence de réflexion (422) de la face interne (42) de l'optique (4) s'étend à l'intérieur de l'ouverture traversante (32) du circuit imprimé (3).

12. Luminaire (1) selon l'une des revendications précédentes, dans lequel une pluralité de moyens d'éclairage à DEL (2) sont montés sur la surface de montage (31) du circuit imprimé (3), qui sont recouverts par une pluralité d'optiques (4) identiques, une des optiques (4) recouvrant respectivement un des moyens d'éclairage à DEL (2).

13. Luminaire (1) selon la revendication 12, dans lequel la pluralité d'optiques (4) sont formées d'un seul tenant.

14. Luminaire (1) selon la revendication 12 ou 13, dans lequel le circuit imprimé (3) présente une pluralité d'ouvertures traversantes (32) en forme de segment de cercle, un de la pluralité de moyens d'éclairage à DEL (2) étant respectivement monté dans le segment de cercle d'une de la pluralité d'ouvertures traversantes (32) et les segments de cercle d'ouvertures traversantes (32) voisines étant tournés les uns par rapport aux autres.
